# EUROPEAN PATENT APPLICATION

(11) **EP 3 780 065 A1**
(43) Date of publication of application: **17.02.2021**
(21) Application number: 19191256.7
(22) Date of filing: 12.08.2019
(51) Int. Cl.: H01J 37/244, G01T 1/24

(54) **CHARGED PARTICLE MICROSCOPE WITH A PIXELATED DETECTOR, AND METHOD OF DETECTING PARTICULATE RADIATION USING A PIXELATED DETECTOR**

(71) Applicant: FEI Company, Hillsboro, OR 97124-5793 (US)
(72) Inventor: Sluijterman, Seyno Albertus Aemillius, 5602 BS Eindhoven (NL); Mele, Luigi, 5602 BS Eindhoven (NL); Bosch, Eric Gerardus Theodoor, 5602 BS Eindhoven (NL); Janssen, Bart Jozef, 5602 BS Eindhoven (NL)
(74) Representative: Janssen, Francis-Paul

(57) **Abstract**

The invention relates to a charged particle microscope for examining a specimen, comprising a charged particle source for providing a charged particle beam; a specimen stage positioned downstream of said charged particle source and arranged for holding said specimen; and a pixelated detector for detecting emissions originating from said specimen in response to the incidence of charged particles emitted from said charged particle source. The pixelated detector comprises a pixel grid having a plurality of physical pixels (205-208). Furthermore, a processing device is provided for processing signals from said pixelated detector, wherein said processing device is arranged for allocating signals from said pixelated detector to a matching sub-pixel grid (211) having a plurality of individual virtual pixels (215-218), wherein the number of virtual pixels exceeds the number of physical pixels. To increase the accuracy of determining the impact of incoming particulate radiation, at least one of said virtual pixels (216) is substantially centered within one of said physical pixels (206).

## Description

The invention relates to a charged particle microscope for examining a specimen, comprising a charged particle source for providing a charged particle beam; a specimen stage positioned downstream of said charged particle source and arranged for holding said specimen; and a pixelated detector for detecting emissions originating from said specimen in response to the incidence of charged particles emitted from said charged particle source, wherein said pixelated detector comprises a pixel grid having a plurality of physical pixels.

Charged particle microscopy is a well-known and increasingly important technique for imaging microscopic objects, particularly in the form of electron microscopy. Historically, the basic genus of electron microscope has undergone evolution into a number of well-known apparatus species, such as the Transmission Electron Microscope (TEM), Scanning Electron Microscope (SEM), and Scanning Transmission Electron Microscope (STEM), and also into various sub-species, such as so-called "dual-beam" apparatus (such as a FIB-SEM, for example), which additionally employ a "machining" Focused Ion Beam (FIB), allowing supportive activities such as ion-beam milling or lon-Beam-Induced Deposition (IBID), for example. The skilled person will be familiar with the different species of charged particle microscopy.

Irradiation of a sample by a scanning electron beam precipitates emanation of "auxiliary" radiation from the sample, in the form of secondary electrons, backscattered electrons, X-rays and cathodoluminescence (infrared, visible and/or ultraviolet photons). One or more components of this emanating radiation may be detected and used for sample analysis.

Semiconductor based pixelated detectors can be used for intercepting radiation in the form of energetic electrons. Each intercepted electron causes a cloud of electron/hole pairs in the semiconductor material of the detector, thereby causing a signal in the detector pixel(s) where it is detected. As the diameter of the cloud (the centroid) is larger than the diameter of the detector pixels, one impinging electron causes a signal in multiple detector pixels, which is also referred to as signal spill. It is possible to use these mutually different signals in multiple detector pixels to more accurately allocate the impact position of the electron within a single pixel. In other words, based on the signal spill in adjacent pixels, it is possible to determine the impact position within a given pixel with more accuracy. This allows a super-resolution, i.e. a resolution that exceeds the detector resolution, to be obtained. One way of doing this resides in assigning the allocated impact position to a matching sub-pixel grid having a plurality of individual virtual pixels. In present methods a virtual pixel grid is used, wherein a physical pixel is sub-divided into four virtual pixels. Thus, a resolution of half a detector pixel diameter can be achieved.

One of the challenges in these super-resolution cameras is that a lot of signal spill is required to accurately determine the impact position. This is not so much a problem for electrons impacting near the boundaries of adjacent physical pixels, as the resulting spill is sufficient to determine the impact location. But an electron impacting at, or near, the centre of the physical pixel results in less signal spill to adjacent physical pixels, which decreases the accuracy with which the location of impact can be determined. Therefore, it is relatively hard to confidently assign the given electron impact to one of the virtual pixels for electrons impacting at, or near, the centre of the physical pixel.

It is therefore an objective to provide a charged particle microscope with which improved detector accuracy, and in particular improved super-resolution, is achievable.

To this end, a charged particle microscope is provided as defined in claim 1. The charged particle microscope comprises a charged particle source for providing a charged particle beam; a specimen stage positioned downstream of said charged particle source and arranged for holding said specimen; and a pixelated detector for detecting emissions originating from said specimen in response to the incidence of charged particles emitted from said charged particle source, wherein said pixelated detector comprises a pixel grid having a plurality of physical pixels.

As defined herein, the charged particle microscope also comprises a processing device for processing signals from said pixelated detector. The processing device is arranged for allocating signals from said pixelated detector to a matching sub-pixel grid having a plurality of individual virtual pixels. The number of virtual pixels exceeds the number of physical pixels. The charged particle microscope comprises a control unit for performing operations of the charged particle microscope. The controller and processing device may be physically integrated into a single device or may alternatively be embodied in separate devices. Said processing device may be part of the control unit or may be part of the pixelated detector, for example. Other embodiments are conceivable as well.

As defined herein, the charged particle microscope is arranged in such a way that at least one of said virtual pixels is substantially centered within one of said physical pixels. Here, the term substantially centered within includes a virtual pixel that is completely enclosed by the physical pixel, i.e. a virtual pixel that does not share any virtual edges with the edges of the physical pixel. The virtual pixel may overlap the center of the physical pixel on all sides, i.e. the virtual pixel comprises the center of the physical pixel. The term centered within includes, in an embodiment, a virtual pixel that is substantially concentric with one of said physical pixels. The term substantially concentric includes embodiments wherein the center of the virtual pixel does not exactly line up with the center of the physical pixel. The virtual pixel may have an offset with respect to the physical pixel. Said offset may, for example, be in the range of 0-50 % relative to the size of the virtual pixel. The center of the virtual pixel may substantially coincide with the center of the physical pixel.

In other words, as defined herein, each physical pixel has a central virtual pixel, with smaller dimensions compared to the physical pixel, assigned thereto. This allows particulate radiation impacting at, or near, the center of the physical pixel to be assigned to said central virtual pixel only, since that is the only option available. The fact that only one virtual pixel is assigned to the center of the physical pixel alleviates the problem of associating particulate radiation impacting the center of the physical pixel to one of multiple possible virtual pixels as described above. In effect, the invention as described herein effectively exploits the fact that the impact position can be determined less accurately for the center of the physical pixel, and more accurately at the circumference of the physical pixel, by establishing a single virtual pixel for the center of the physical pixel only. With this, improved accuracy, and improved super-resolution is obtained, and the object as defined herein is achieved.

Advantageous embodiments will be described below.

It is noted that the invention as described herein can be used with particulate radiation from the group of electron, ions, and X-ray photons. In the following, reference may be made to electrons only for reasons of conciseness. It will be understood by those skilled in the art that the reference to electrons only is not intended to be limited to the invention.

In an embodiment, at least one of said virtual pixels is associated with at least two physical pixels. This exploits the fact that electron impact can be determined more accurately at the edges of the virtual pixels. It is conceivable that at least one of said virtual pixels overlaps with two physical pixels. In particular, the center of the virtual pixel may coincide with the edge of the physical pixel.

In an embodiment, at least one of said virtual pixels is associated with four physical pixels. This embodiment exploits the fact that electron impact can be determined more accurately at the edges of the virtual pixels. It is conceivable that the center of this virtual pixel coincides with one or more of the corner points of said four physical pixels.

In a first embodiment, the ratio of physical pixels to virtual pixels is 1:4. This allows a super-resolution of half a detector pixel diameter to be achieved.

It is conceivable that at least one physical pixel is associated with one full virtual pixel, four half virtual pixels, and four quarter virtual pixels, effectively yielding a ratio of physical pixels to virtual pixels of 1:4. The virtual pixels may form a regular or 2D cartesian grid, which aids in the further processing of the acquired data.

In a second embodiment, the ratio of physical pixels to virtual pixels is 1:9. This allows a super-resolution of a third of a detector pixel diameter to be achieved.

It is conceivable that at least one physical pixel is associated with nine full virtual pixels, effectively yielding a ratio of physical pixels to virtual pixels of 1:9. The virtual pixels may form a regular or 2D cartesian grid, which aids in the further processing of the acquired data. Of the nine full virtual pixels, one is a central virtual pixel with a center that at least substantially coincides with the associated physical pixel. Four virtual pixels are edge pixels, each having a virtual edge that coincides with an edge of the physical pixel. Four pixels are corner pixels, each having a virtual corner point that coincides with the corner of the physical pixel.

In an embodiment, said sub-pixel grid comprises a regular grid of virtual pixels. Said regular grid may comprise rectangular pixels. In an advantageous embodiment, the grid comprises square pixels. This aids in the further processing of the acquired data.

In an embodiment, the regular grid of virtual pixels comprises n x n virtual pixels for each physical pixel, such as 2 x 2, 3 x 3, 4 x 4, 5 x5, and so on. For n being an even number, there may be virtual pixels that overlap two or more physical pixels. For n being an odd number, one physical pixel can be associated with full virtual pixels only. Examples have been given above for a 2 x 2 and 3 x 3 virtual pixel grid per physical pixel, and these embodiments will be described with respect to the drawings as well.

According to an aspect, a method of detecting particulate radiation using a pixelated detector is provided. According to this method, use is made of a pixelated detector comprising a pixel grid having a plurality of physical pixels. The pixelated detector may be a semiconductor based pixelated detector.

As defined herein, the method comprises the steps of collecting, on a first physical pixel, a particle of the particulate radiation. In particular, the particle impacts the detector at an impact location that coincides with the first physical pixel.

The method comprises the step of estimating, using signals of said first physical pixel and at least one of the physical pixels adjacent to said first physical pixel, a position of impact of said particle on said first detector pixel. Using the signals of the physical pixels involved in the impact of the particle, the impact location of said particle can be estimated, wherein in particular use is made of the aforementioned signal spill.

The method further comprises the step of allocating said position of impact to a matching sub-pixel grid having a plurality of individual virtual pixels, wherein a plurality of virtual pixels is associated with said first physical pixel, and wherein at least one of said virtual pixels is centered within said first physical pixel. By using such a virtual pixel, for example having a center that substantially coincides with the center of the physical pixel, it is possible to assign all particles that impact near the center of the physical pixel to said central virtual pixel only. The fact that determining the location of impact is relatively difficult for particles impacting at, or near, the center of the physical pixel, is now alleviated by the fact that these particles can be allocated to a single virtual pixel only. This improves the accuracy of the method, in particular as the accuracy and resolution can be increased this way for particles impacting near the edges of the physical pixel. With this, the object is achieved.

As known to those skilled in the art, the impact of the particle may cause a multitude of electron/hole pairs in the semiconductor material of the detector. The multitude of electron/hole pairs each have a centroid and a centroid extent. Said extent of the centroid may be larger than the detector pixel size. With this in mind, the method as described above may include the additional steps of:
- estimating the number of electron/hole pairs for a number of adjacent detector pixels;
- estimating the position of the centroid of the number of electron/hole pairs using the estimates of electron/hole pairs in adjacent detector pixels; and
- estimating the impact position of the particle using said estimated position of the centroid.

It is noted that these additional steps and further steps are described in US patent number US 10,122,946 B1 in name of applicant. In particular, this patent describes that the contribution of each estimated impact position may be adjusted to corresponding image pixels to counter the effect of a position dependent bias. The method as defined herein may include said step of adjusting to counter the effect of said position dependent bias as well. For a complete description of the effect of position dependent bias, and how to counter it, the reader is referred to the US 10,122,946 B1 as cited above.

In an embodiment, the method may comprise the step of allocating said position of impact to said centered or concentric virtual pixel. In particular, the method may comprise the step of allocating all impacts hitting at or near the center to said centered or concentric virtual pixel. The term "at or near the center" may be defined as a central region of the physical pixel that:
- comprises the geometrical center of the physical pixel;
- is substantially concentric with said geometrical center; and
- has a width dimension of at most 50% of the width of the physical pixel and a height dimension of at most 50% of the height of the physical pixel.

In embodiments, the central region has a width dimension of at most 33% of the width of the physical pixel and a height dimension of at most 33% of the height of the physical pixel.

The central virtual pixel may substantially coincide with the "at or near the center" region of the physical pixel, as defined above.

In an embodiment, the method comprises the step of forming a pixelated image using the estimated position of a multitude of estimated impact positions, and using the associated virtual pixels, the pixelated image consisting of image pixels having an intensity.

The invention will now be elucidated in more detail on the basis of exemplary embodiments and the accompanying schematic drawings, in which:
Fig. 1 - shows a longitudinal cross-sectional view of a charged particle microscope according to a first embodiment of the invention;
Fig. 2 - shows a longitudinal cross-sectional view of a charged particle microscope according to a second embodiment of the invention;
Fig. 3a and 3b - shows a pixel and a virtual sub-pixel grid according to the prior art;
Fig. 4 - shows a pixel grid and a virtual sub-pixel grid according to a first embodiment; and
Fig. 5 - shows a pixel grid and a virtual sub-pixel grid according to a second embodiment.

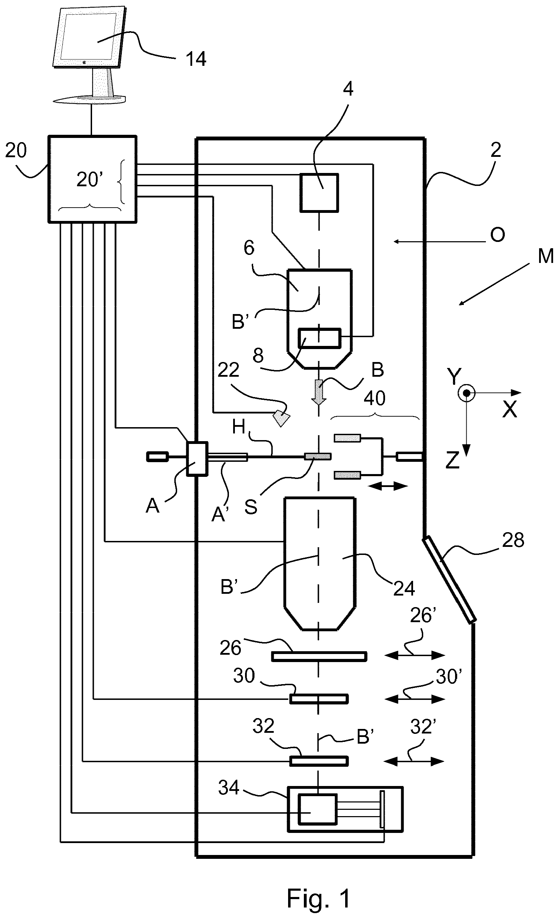

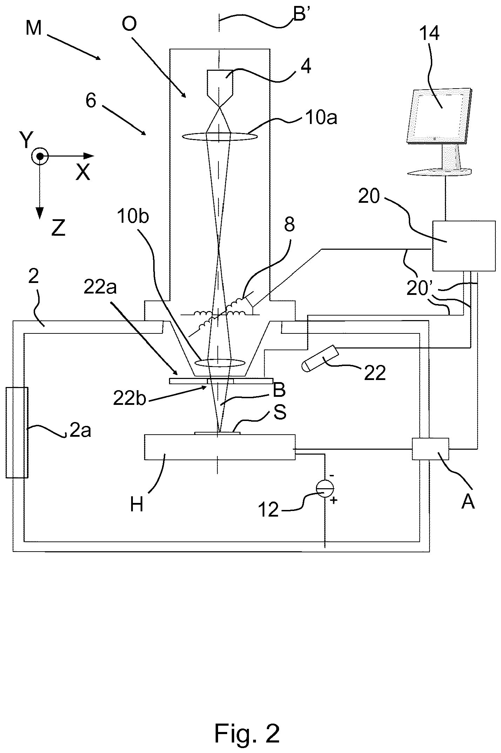

Fig. 1 (not to scale) is a highly schematic depiction of an embodiment of a charged-particle microscope M according to an embodiment of the invention. More specifically, it shows an embodiment of a transmission-type microscope M, which, in this case, is a TEM/STEM (though, in the context of the current invention, it could just as validly be a SEM (see Figure 2), or an ion-based microscope, for example). In Fig. 1, within a vacuum enclosure 2, an electron source 4 produces a beam B of electrons that propagates along an electron-optical axis B' and traverses an electron-optical illuminator 6, serving to direct/focus the electrons onto a chosen part of a specimen S (which may, for example, be (locally) thinned/planarized). Also depicted is a deflector 8, which (*inter alia*) can be used to effect scanning motion of the beam B.

The specimen S is held on a specimen holder H that can be positioned in multiple degrees of freedom by a positioning device / stage A, which moves a cradle A' into which holder H is (removably) affixed; for example, the specimen holder H may comprise a finger that can be moved (*inter alia*) in the XY plane (see the depicted Cartesian coordinate system; typically, motion parallel to Z and tilt about X/Y will also be possible). Such movement allows different parts of the specimen S to be illuminated / imaged / inspected by the electron beam B traveling along axis B' (in the Z direction) (and/or allows scanning motion to be performed, as an alternative to beam scanning). If desired, an optional cooling device (not depicted) can be brought into intimate thermal contact with the specimen holder H, so as to maintain it (and the specimen S thereupon) at cryogenic temperatures, for example.

The electron beam B will interact with the specimen S in such a manner as to cause various types of "stimulated" radiation to emanate from the specimen S, including (for example) secondary electrons, backscattered electrons, X-rays and optical radiation (cathodoluminescence). If desired, one or more of these radiation types can be detected with the aid of analysis device 22, which might be a combined scintillator/photomultiplier or EDX or EDS (Energy-Dispersive X-Ray Spectroscopy) module, for instance; in such a case, an image could be constructed using basically the same principle as in a SEM. However, alternatively or supplementally, one can study electrons that traverse (pass through) the specimen S, exit/emanate from it and continue to propagate (substantially, though generally with some deflection/scattering) along axis B'. Such a transmitted electron flux enters an imaging system (projection lens) 24, which will generally comprise a variety of electrostatic / magnetic lenses, deflectors, correctors (such as stigmators), *etc.* In normal (non-scanning) TEM mode, this imaging system 24 can focus the transmitted electron flux onto a fluorescent screen 26, which, if desired, can be retracted/withdrawn (as schematically indicated by arrows 26') so as to get it out of the way of axis B'. An image (or diffractogram) of (part of) the specimen S will be formed by imaging system 24 on screen 26, and this may be viewed through viewing port 28 located in a suitable part of a wall of enclosure 2. The retraction mechanism for screen 26 may, for example, be mechanical and/or electrical in nature, and is not depicted here.

As an alternative to viewing an image on screen 26, one can instead make use of the fact that the depth of focus of the electron flux leaving imaging system 24 is generally quite large (*e.g.* of the order of 1 meter). Consequently, various other types of analysis apparatus can be used downstream of screen 26, such as:
- TEM camera 30. At camera 30, the electron flux can form a static image (or diffractogram) that can be processed by controller/processor 20 and displayed on a display device (not depicted), such as a flat panel display, for example. When not required, camera 30 can be retracted/withdrawn (as schematically indicated by arrows 30') so as to get it out of the way of axis B'.
- STEM camera 32. An output from camera 32 can be recorded as a function of (X,Y) scanning position of the beam B on the specimen S, and an image can be constructed that is a "map" of output from camera 32 as a function of X,Y. Camera 32 can comprise a single pixel with a diameter of e.g. 20 mm, as opposed to the matrix of pixels characteristically present in camera 30. Moreover, camera 32 will generally have a much higher acquisition rate (*e.g.* 10⁶ points per second) than camera 30 (e.g. 10² images per second). Once again, when not required, camera 32 can be retracted/withdrawn (as schematically indicated by arrows 32') so as to get it out of the way of axis B' (although such retraction would not be a necessity in the case of a donut-shaped annular dark field camera 32, for example; in such a camera, a central hole would allow flux passage when the camera was not in use).
- As an alternative to imaging using cameras 30 or 32, one can also invoke spectroscopic apparatus 34, which could be an EELS module, for example.

It should be noted that the order/location of items 30, 32 and 34 is not strict, and many possible variations are conceivable. For example, spectroscopic apparatus 34 can also be integrated into the imaging system 24.

One or more of the items 30 or 32 (i.e. TEM camera 30 and/or STEM camera 32) and 34 may be embodied as a pixelated detector for detecting emissions originating from said specimen in response to the incidence of charged particles emitted from said charged particle source. Said pixelated detector comprises a pixel grid having a plurality of physical pixels. Said pixelated detector may be provided with a processing device for performing functions of said pixelated detector, which functions in particular include the processing of signals acquired by said detector. Such processing may include allocating signals from said pixelated detector to a matching sub-pixel grid having a plurality of individual virtual pixels, as will be explained later.

It is furthermore noted that the controller and processing device may be physically integrated into a single device or may alternatively be embodied in separate devices. Said processing device may be part of the control unit 20 or may be part of the pixelated detector 30, 32, for example. Other embodiments are conceivable as well.

In the embodiment shown in Fig. 1, the microscope M further comprises a retractable X-ray Computed Tomography (CT) module, generally indicated by reference 40. In Computed Tomography (also referred to as tomographic imaging) the source and (diametrically opposed) detector are used to look through the specimen along different lines of sight, so as to acquire penetrative observations of the specimen from a variety of perspectives.

Note that the controller (computer processor) 20 is connected to various illustrated components via control lines (buses) 20'. This controller 20 can provide a variety of functions, such as synchronizing actions, providing setpoints, processing signals, performing calculations, and displaying messages/information on a display device (not depicted). Needless to say, the (schematically depicted) controller 20 may be (partially) inside or outside the enclosure 2, and may have a unitary or composite structure, as desired.

The skilled artisan will understand that the interior of the enclosure 2 does not have to be kept at a strict vacuum; for example, in a so-called "Environmental TEM/STEM", a background atmosphere of a given gas is deliberately introduced / maintained within the enclosure 2. The skilled artisan will also understand that, in practice, it may be advantageous to confine the volume of enclosure 2 so that, where possible, it essentially hugs the axis B', taking the form of a small tube (*e.g.* of the order of 1 cm in diameter) through which the employed electron beam passes, but widening out to accommodate structures such as the source 4, specimen holder H, screen 26, camera 30, camera 32, spectroscopic apparatus 34, *etc.*

The charged particle microscope M according to the invention, and of which an embodiment is shown in Fig. 1, thus comprises a charged particle source 4 for providing a charged particle beam B, a specimen stage A,H positioned downstream of said charged particle source 4 and arranged for holding said specimen S. The apparatus furthermore comprises a pixelated detector 30, 32 for detecting emissions originating from said specimen S in response to the incidence of charged particles emitted from said charged particle source 4, wherein said pixelated detector comprises a pixel grid having a plurality of physical pixels. Furthermore, the apparatus according to the invention comprises the control unit 20 that is connected (by means of lines 20') to said pixelated detector 30, 32 (schematically shown). In the embodiment shown, the pixelated detector 30, 32 comprises said processing device 30, 32; although it is conceivable that the processing device is part of the control unit 20.

Now first referring to Fig. 2, another embodiment of an apparatus according to the invention is shown. Fig. 2 (not to scale) is a highly schematic depiction of a charged-particle microscope M according to the present invention; more specifically, it shows an embodiment of a non-transmission-type microscope M, which, in this case, is a SEM (though, in the context of the current invention, it could just as validly be an ion-based microscope, for example). In the Figure, parts which correspond to items in Figure 1 are indicated using identical reference symbols, and will not be separately discussed here. Additional to Figure 1 are (*inter alia*) the following parts:
- 2a: A vacuum port, which may be opened so as to introduce/remove items (components, specimens) to/from the interior of vacuum chamber 2, or onto which, for example, an ancillary device/module may be mounted. The microscope M may comprise a plurality of such ports 2a, if desired;
- 10a, 10b: Schematically depicted lenses / optical elements in illuminator 6;
- 12: A voltage source, allowing the specimen holder H, or at least the specimen S, to be biased (floated) to an electrical potential with respect to ground, if desired;
- 14: A display, such as a FPD or CRT;
- 22a, 22b: A pixelated detector 22a, comprising a plurality of independent detection segments (*e.g.* quadrants) disposed about a central aperture 22b (allowing passage of the beam B). Such a detector can, for example, be used to investigate (the angular dependence of) a flux of output (secondary or backscattered) electrons emerging from the specimen S. The pixelated detector 22a can alternatively be embodied without said central aperture 22b.

Thus the charged particle microscope M as shown in Fig. 2 comprises a charged particle source 4 for providing a charged particle beam B, a specimen stage A,H positioned downstream of said charged particle source 4 and arranged for holding said specimen S. The apparatus furthermore comprises a pixelated detector 22a for detecting emissions originating from said specimen S in response to the incidence of charged particles emitted from said charged particle source 4, wherein said pixelated detector comprises a pixel grid having a plurality of physical pixels. Furthermore, the apparatus according to the invention comprises the control unit 20 that is connected (by means of lines 20') to said pixelated detector 22a (schematically shown). In the embodiment shown, processing device is part of the control unit 20.

In general, the invention relates to the processing of signals from the pixelated detector, wherein signals from said pixelated detector are allocated to a matching (virtual) sub-pixel grid having a plurality of individual virtual pixels.

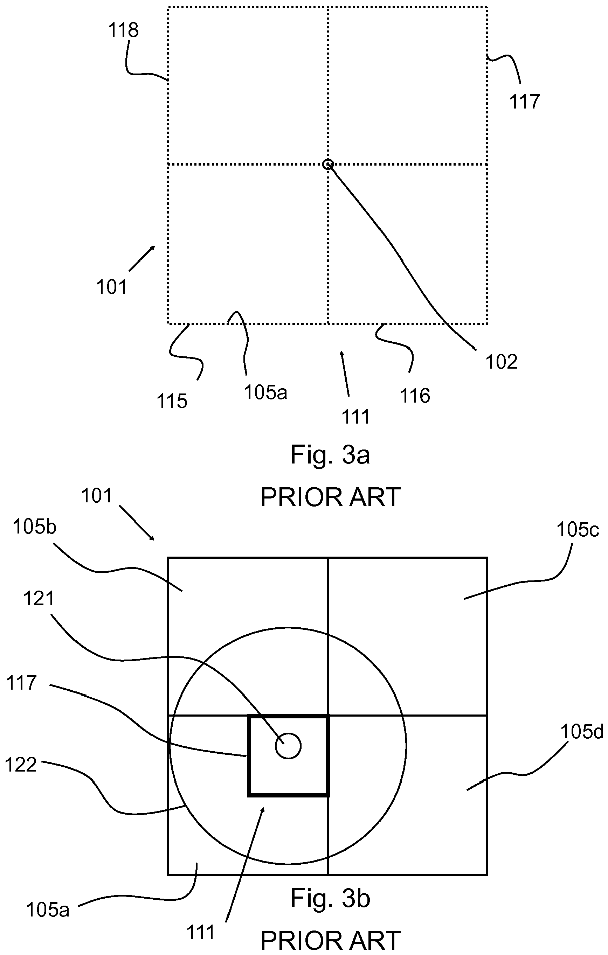

According to the prior art, as shown in Fig. 3a, a pixelated detector 101 comprises a number of physical pixels 105a-d (only one of which is shown in Fig. 3). Each physical pixel 105a-d has a geometrical center point 102. A sub-pixel grid 111 is used that divides the physical pixel 105 evenly into four virtual pixels 115-118. Edges of the virtual pixels 115-118 are aligned with the edges of the physical pixel 105. The center 102 of the physical pixel coincides with four corners of the virtual pixels 115-118.

Fig. 3b shows a pixelated detector 101 having a number of physical pixels 105a-d, using a method according to the prior art. An impinging electron 121 hits the lower-left physical pixel 105a, near the upper right corner of that lower-left physical pixel 105a. Here, the impinging electron 121 not only causes a charge in the respective pixel 105a, but also in multiple surrounding detector pixels 105b-105d. This is referred to as signal spill. The impinging electron 121 provides a charge in pixels in an area 122 surrounding the impact location 121, as indicated by sphere 122, and pixels 105a-d affected by this sphere will collect a certain amount of charge. The magnitude of the charge is largely based on the area of the sphere 122 covering the respective pixel. Hence, lower-left physical pixel 105a will obtain the highest charge, upper-left and lower-right physical pixels 105b-105d will obtain substantially lower charges, and upper-right physical pixel 105c will obtain the lowest charge. By mathematically comparing the charges in the affected physical pixels 105a-d, it becomes possible to reduce an impact event 121 to a pixel 105a receiving the highest charge, and to localize it to subpixel 117 accuracy. In the embodiment shown, since physical pixel 105a receives the highest charge, and upper and right physical pixels receive charges as well, it is clear that the impinging electron 121 hit the upper right subpixel 117 of physical pixel 105a.

An electron hitting near the edge of the physical pixel, as shown in the embodiment of Fig. 3b, yields a relatively high spill in adjacent pixels, and hence the impact position of the electron can be determined accurately. As a consequence, the allocating of the impact to a virtual pixel 115-118 is relatively easy. However, for electrons hitting at or near the center 102 of the physical pixel, there is less signal spill to adjacent pixels, and so the impact position can be determined with less accuracy. This poses a problem, as this decreases the confidence with which the impact can be assigned to one of four virtual pixels 115-118 that corner each other at the center 102 of the physical pixel 105. Consequently, a bias may be introduced in assigning the impact to a virtual pixel.

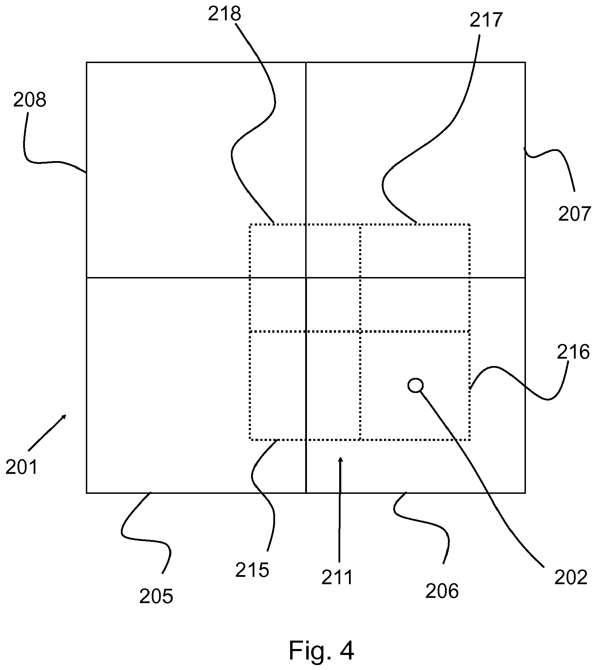

The invention as described herein counters this bias, by using a central, such as a concentric, virtual pixel. As shown in Fig. 4, a virtual sub-pixel grid 211 is used that divides a physical pixel 205-208 into a total of four virtual pixels 215-218. For each physical pixel 206, there is a virtual pixel 216 that is positioned substantially concentric with one of said physical pixels. In the embodiment shown, the virtual sub-pixel grid 211 is shifted with respect to the physical pixel grid 201. By using a concentric virtual pixel 216, it becomes easier to assign impacts at or near the center of the physical pixel 206, as there is basically only one option for assigning the impact for this region. For impacts at or near the edges the impact location can be determined more accurately due to the increased signal spill. The increased accuracy decreases the aforementioned problem of allocating an impact that occurs near the corners of the virtual pixel (i.e. the center of the physical pixel in the embodiment of Fig. 3).

As can be seen in Fig. 4, some virtual pixels 215, 217 are associated with at least two physical pixels 205, 206; 207, 206. Additionally, in this embodiment, one of the virtual pixels 218 is associated with four physical pixels 205, 206, 207, 208. This virtual pixel 218 has its geometrical center aligned with the corners of these four physical pixels 205-208. In the embodiment shown in Fig. 4, only part of the sub-pixel grid is shown. The sub-pixel grid 211 may extend over the entire pixel grid. In this case, the sub-pixel grid 211 is a regular grid, and in particular a Cartesian grid having square virtual pixels. Other embodiments are conceivable as well. It is noted furthermore that a single physical pixel 206 comprises one full virtual pixel (the concentric central pixel 216), four half virtual pixels 215, 217, (...), and four quarter virtual pixels 218, (...).

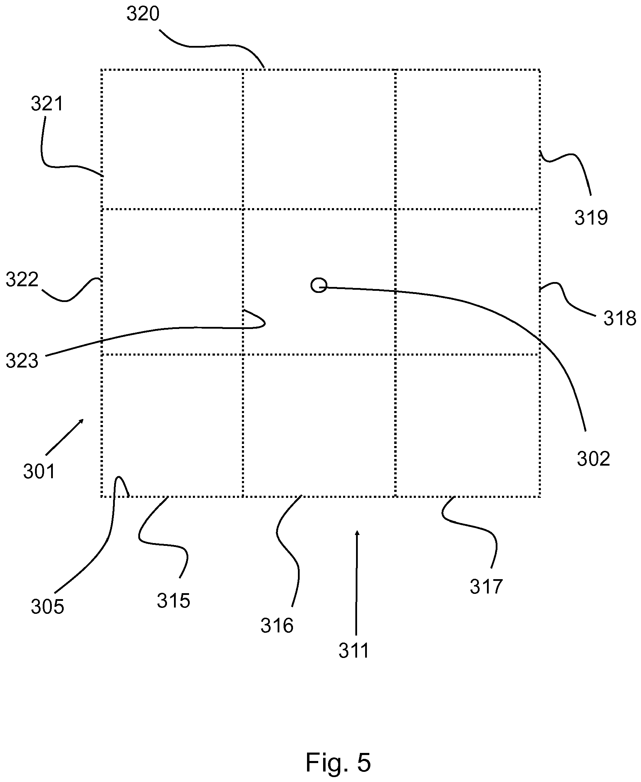

In the embodiment of Fig. 5, a central concentric virtual pixel 323 is used, just like in Fig. 4. Here, however, the number of virtual pixels 315-323 to physical pixels 305 is increased from 4:1 to 9:1. The use of the concentric virtual pixel 323 allows the size of the virtual pixels 315-323 of the virtual sub-pixel grid 311 to be decreased, rendering an increased super-resolution. In this embodiment, the physical pixel 305 is associated with nine full virtual pixels 315-323.

Above, the invention has been explained with reference to exemplary embodiments. The desired protection is conferred by the appended claims.

## Claims

1. A charged particle microscope for examining a specimen, comprising:
- a charged particle source for providing a charged particle beam;
- a specimen stage positioned downstream of said charged particle source and arranged for holding said specimen;
- a pixelated detector for detecting emissions originating from said specimen in response to the incidence of charged particles emitted from said charged particle source, wherein said pixelated detector comprises a pixel grid having a plurality of physical pixels;
- a processing device for processing signals from said pixelated detector, wherein said processing device is arranged for allocating signals from said pixelated detector to a matching sub-pixel grid having a plurality of individual virtual pixels, wherein the number of virtual pixels exceeds the number of physical pixels; and
- a control unit for performing operations of the charged particle microscope.
**Characterized in that** at least one of said virtual pixels is substantially centered within one of said physical pixels.

2. A charged particle microscope according to claim 1, wherein said at least one of said virtual pixels is substantially concentric with said one of said physical pixels.

3. A charged particle microscope according to claim 1 or 2, wherein at least one of said virtual pixels is associated with at least two physical pixels.

4. A charged particle microscope according to claim 1-3, wherein at least one of said virtual pixels is associated with four physical pixels.

5. A charged particle microscope according to claim 1-4, wherein at least one physical pixel is associated with one full virtual pixel, four half virtual pixels, and four quarter virtual pixels.

6. A charged particle microscope according to claim 5, wherein the ratio of physical pixels to virtual pixels is 1:4.

7. A charged particle microscope according to claim 1-4, wherein at least one physical pixel is associated with nine full virtual pixels.

8. A charged particle microscope according to claim 7, wherein the ratio of physical pixels to virtual pixels is 1:9.

9. A charged particle microscope according to claim 1-8, wherein said sub-pixel grid comprises a regular grid of virtual pixels.

10. A method of detecting particulate radiation using a pixelated detector, wherein said pixelated detector comprises a pixel grid having a plurality of physical pixels, wherein the method comprises the steps of:
- collecting, on a first physical pixel, a particle of the particulate rad iation;
- estimating, using signals of said first physical pixel and at least one of the physical pixels adjacent to said first physical pixel, a position of impact of said particle on said first detector pixel;
- allocating said position of impact to a matching sub-pixel grid having a plurality of individual virtual pixels, wherein a plurality of virtual pixels is associated with said first physical pixel, and wherein at least one of said virtual pixels is substantially centered within said first physical pixel.

11. Method according to claim 10, wherein said at least one of said virtual pixels is substantially concentric with said one of said physical pixels.

12. Method according to claim 10 or 11, comprising the step of allocating said position of impact to said centered virtual pixel.

13. Method according to claim 10-12, comprising the step of forming a pixelated image using the estimated position of a multitude of estimated impact positions, and using the associated virtual pixels, the pixelated image consisting of image pixels having an intensity.
